# EUROPÄISCHE PATENTSCHRIFT

(11) **EP 1 782 085 B1**
(45) Veröffentlichungstag und Bekanntmachung des Hinweises auf die Patenterteilung: **21.06.2017**
(21) Anmeldenummer: 05769685.8
(22) Anmeldetag: 11.07.2005
(51) Int. Cl.: G01R 29/26

(54) **VERFAHREN ZUM MESSEN DES PHASENRAUSCHENS EINES HOCHFREQUENZSIGNALS UND MESSGERÄT ZUM AUSFÜHREN DIESES VERFAHRENS**
METHOD FOR MEASURING THE PHASE JITTER OF A HIGH-FREQUENCY SIGNAL, AND MEASURING UNIT FOR CARRYING OUT THIS METHOD
PROCEDE POUR MESURER LE BRUIT DE PHASE D'UN SIGNAL HAUTE FREQUENCE ET APPAREIL DE MESURE PERMETTANT DE METTRE EN OEUVRE CE PROCEDE

(30) Priorität: 03.08.2004 DE 102004037577
(43) Veröffentlichungstag der Anmeldung: 09.05.2007
(73) Patentinhaber: Rohde & Schwarz GmbH & Co. KG, 81671 München (DE)
(72) Erfinder: ROTH, Alexander, 84405 Dorfen (DE)
(74) Vertreter: Körfer, Thomas
(86) Internationale Anmeldenummer: PCT/EP2005/007495
(87) Internationale Veröffentlichungsnummer: WO 2006/015677

(56) Entgegenhaltungen:
- US-A- 5 818 215
- US-A1- 2003 080 724
- US-B1- 6 313 619
- ANONYMUS: "Measuring Phase Noise with theAgilent PN 894400-2: Agilent 89400 Series Vector Signal Analyzers"[Online] 1. September 2000 (2000-09-01), XP002352044 Gefunden im Internet: URL:http://cp.literature.agilent.com/litwe b/pdf/5091-7193E.pdf> [gefunden am 2005-10-31]

## Beschreibung

Die Erfindung betrifft ein Verfahren zum Messen des Phasenrauschens eines Hochfrequenzsignals mittels eines Spektrumanalysators sowie ein Meßgerät zum Ausführen dieses Verfahrens.

Zum Messen des Phasenrauschens eines Hochfrequenzsignals, beispielsweise des Ausgangssignals eines Oszillators, wird bisher meist ein Meßplatz benutzt, der aus mehreren relativ teuren und schwierig zu bedienenden Einzelgeräten besteht, meist einem Signalgenerator, einem Spektrumanalysator zur Niederfrequenz-Fast-Fourier-Transformation (FFT), einem Steuerrechner sowie einem zusätzlichen Mischer. Zur Phasenrauschmessung wird das zu messende Hochfrequenzsignal mit einem im Signalgenerator erzeugten Vergleichssignal gleicher Frequenz gemischt. Der Mischer liefert damit ein Ausgangssignal, das die Differenzfrequenz zwischen dem zu messenden Hochfrequenzsignal und dem Vergleichssignal ist und damit ein Maß für das Phasenrauschen darstellt. Die Auswertung dieses Differenzfrequenzsignals erfolgt nach Verstärkung in einem rauscharmen Verstärker mit Hilfe des FFT-Spektrumanalysators. Durch das Mischen der beiden Signale auf 0 Hz wird eine eventuell vorhandene AM-Modulation des Signals unterdrückt, da sich die beiden gleichphasigen Seitenbänder auslöschen. Bei Frequenzmodulation (FM) des zu messenden Hochfrequenzsignals sind die Seitenbänder gegenphasig, ihr Beitrag addiert sich daher im Mischer.

Ein solcher bekannter Meßplatz zum Messen von Phasenrauschen unterscheidet somit zwischen AM- und FM-Rauschen und erlaubt auch das Vermessen von guten Oszillatoren. Es setzt jedoch einen sehr guten rauscharmen Signalgenerator im entsprechenden Frequenzbereich voraus. Häufig ist noch ein HF-Spektrumanalysator erforderlich, um das Meßsignal in der Frequenz zu bestimmen, und ein Oszilloskop, um die Synchronisation zu prüfen. Ein solcher bekannter Meßplatz ist daher relativ aufwendig, teuer und schwierig zu bedienen.

Das Phasenrauschen kann im Prinzip auch mit einem Spektrumanalysator gemessen werden. Der klassische Spektrumanalysator kann jedoch nicht zwischen AM- und FM-Modulation unterscheiden. Bei einem Oszillator soll aber im allgemeinen nur der FM-Anteil gemessen werden. Bei modernen Spektrumanalysatoren mit digitaler Auswertung der letzten Zwischenfrequenz kann zwar die AM- und FM-Modulation getrennt gemessen werden. Der Dynamik-Bereich der verwendeten A/D-Wandler ist jedoch nicht ausreichend, um auch gute rauscharme Oszillatoren zu messen. Ein Beispiel eines Spektrumanalysators mit integrierter Phasenrauschmessung ist in US2003/0080724 A1 offenbart.

Es ist daher Aufgabe der Erfindung, ein einfaches und preiswertes Meßgerät zum Ausführen eines Verfahrens nach dem eine Phasenrauschmessung mit einer Qualität durchführbar ist, wie sie bisher nur mit teuren Meßplätzen möglich ist, aufzuzeigen.

Diese Aufgabe wird durch ein Meßgerät laut Anspruch 1 gelöst. Vorteilhafte Weiterbildungen ergeben sich aus den Unteransprüchen.

Gemäß der Erfindung kann mit einer einfachen zusätzlichen Baugruppe (Mischer, Frequenzvervielfacher und Frequenzteiler sowie Umschalter) ein üblicher Spektrumanalysator mit der heute üblichen digitalen Auswertung zu einem hochwertigen Phasenrauschanalysator erweitert werden, der in einem einzigen Geräte alle Meßfunktionen eines Phasenrausch-Meßplatzes und eines Spektrumanalysators vereint und der es bei einfachster Bedienung ohne zusätzlichen Signalgenerator ermöglicht, auch gute rauscharme Oszillatoren bezüglich Phasenrauschen zu messen. Ein entsprechendes Meßverfahren besitzt bezüglich Grundrauschen eine hohe Meßdynamik und liefert außerdem gute Werte für das trägernahe Phasenrauschen. Bei dem Verfahren wird beispielsweise die Ausgangsfrequenz des durchstimmbaren ersten Oszillators des Spektrumanalysators, die im Spektrumanalysatorbetrieb oberhalb des Eingangsfrequenzbereiches liegt, in der Betriebsart "Phasenrauschmessung" durch einen Frequenzteiler geteilt, so daß deren Phasenrauschen um 20·logN (N=Teilungsfaktor des Frequenzteilers) verbessert und hierdurch die gewünschte Qualität erreicht wird.

Eine andere Möglichkeit besteht darin, das bezüglich Phasenrauschen zu messende Hochfrequenzsignal durch einen Frequenzvervielfacher (Vervielfachungsfaktor M) in der Frequenz zu vervielfachen und entweder mit der ungeteilten oder mit einer in der Frequenz geteilten Ausgangsfrequenz des durchstimmbaren ersten Oszillators zu mischen, auch hierdurch wird die gewünschte Meßqualität erreicht. Frequenzvervielfachung M und Frequenzteilung N werden vorzugsweise so gewählt und aufeinander abgestimmt, daß deren schaltungstechnische Realisierung am einfachsten wird und trotzdem die gewünschte Meßqualität erreicht wird. Frequenzvervielfacher und Frequenzteiler sind insbesondere in ihren Faktoren M bzw. N einstellbar, am zweckmäßigsten auf ganzzahlige Vielfache.

Trotz dieser Umschaltmöglichkeit auf eine hochwertige Phasenrauschmessung bleibt die Funktionalität des dazu ergänzten Spektrumanalysators voll erhalten und kann wie üblich beispielsweise dazu benutzt werden, ein unbekanntes Eingangssignal in Bezug auf Frequenz und Pegel zu analysieren.

Für eine anschließende Phasenrauschmessung ist es nur erforderlich, die im Spektrumanalysator vorhandenen Baugruppen in ähnlicher Weise zusammenzuschalten, wie dies beim eingangs erwähnten klassischen Phasenrauschmeßplatz üblich ist. Im Prinzip kann jeder Spektrumanalysator gemäß der Erfindung zum Phasenrauschanalysator ergänzt werden, auch solche mit analoger FFT-Auswertung. Besonders geeignet hierfür sind jedoch moderne Spektrumanalysatoren mit digitaler Auswertung in der letzten Zwischenfrequenz.

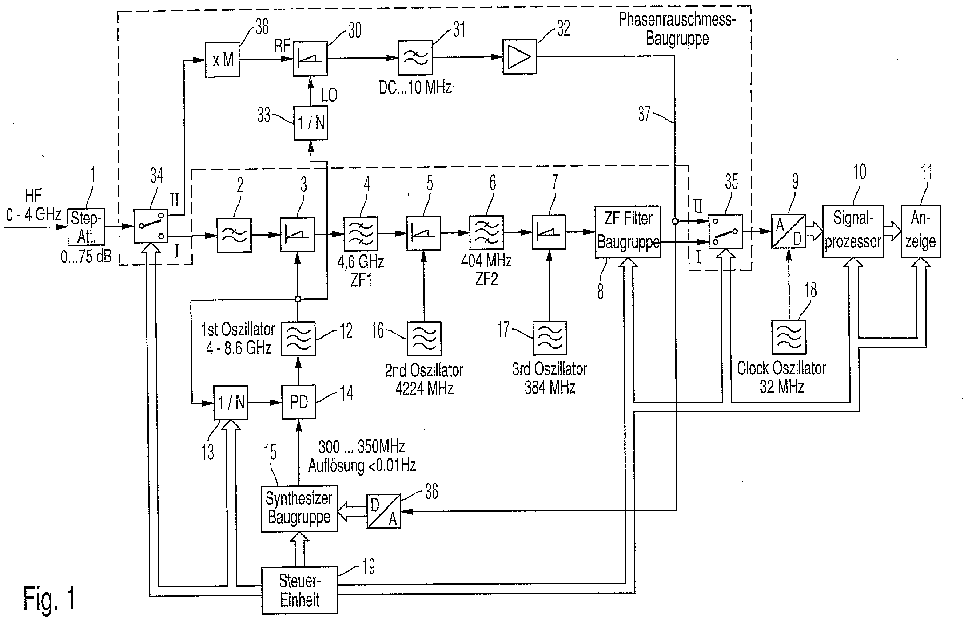

Die Erfindung wird im Folgenden anhand einer schematischen Zeichnung an einem Ausführungsbeispiel näher erläutert. Es zeigt Fig. 1 das Blockschaltbild eines erfindungsgemäßen Spektrumanalysators.

Die einzelnen Baugruppen des Spektrumanalysators sind in der Fig. 1 mit den Bezugszeichen 1 bis 19 bezeichnet. Die zusätzlichen Baugruppen, durch die dieser Spektrumanalysator zu einem Meßgerät zum Messen des Phasenrauschens ergänzt werden, sind mit Bezugszeichen größer als 30 bezeichnet.

Bei Betrieb des Meßgeräts als Spektrumanalysator wird das hochfrequente Eingangssignal HF über einen einstellbaren Abschwächer 1 und den die Schaltstellung I einnehmenden Eingangs- Umschalter 34 dem Eingangs-Tiefpaß 2 und von dort dem Eingangs-Mischer 3 zugeführt. Der Eingangs-Tiefpaß 2 sorgt für eine eindeutige Abbildung des Eingangssignals, da die erste Zwischenfrequenz ZF1 oberhalb des Eingangsfrequenzbereiches liegt. Die erste Frequenzumsetzung im Eingangs-Mischer 3 erfolgt mit der Ausgangsfrequenz eines phasengeregelten Oszillators 12, dessen in einem gesteuerten Frequenzteiler 13 geteilte Ausgangsfrequenz in einem Phasenkomparator 14 mit der Ausgangsfrequenz eines Frequenzsynthesizers 15 synchronisiert ist. Der Synthesizer 15 ist über die Steuereinheit 19 so gesteuert, daß er eine kontinuierlich sich ändernde Ausgangsfrequenz erzeugt.

Die erste Zwischenfrequenz ZF1 wird in einem Bandpaß 4 gefiltert, so daß auch bei der Frequenzumsetzung zur zweiten Zwischenfrequenz ZF2 im zweiten Mischer 5 mittels der festen Überlagerungsfrequenz eines Oszillators 16 kein Spiegelempfang entsteht. Gleiches gilt für den Bandpaß 6 in Verbindung mit dem nachfolgenden Mischer 7 und Frequenzumsetzung mittels eines festen Oszillators 17. Üblicherweise werden drei derartige Frequenzumsetzungen gewählt, um die Realisierung des Bandpasses auf der ersten Zwischenfrequenz zu vereinfachen.

Die resultierende Zwischenfrequenz ZF3 wird in einer analogen ZF-Filter-Baugruppe 8 weiterverarbeitet, die Signale werden zum einen auf einen für den nachfolgenden A/D-Wandler 9 günstigen Pegelbereich verstärkt und zum anderen auch mit einer Bandbreite vorgefiltert, die etwas größer ist als die digital realisierte Auflösebandbreite in der nachfolgenden digitalen Signalverarbeitung, um so Übersteuerungen des A/D-Wandlers 9 zu vermeiden. Die Zufuhr des Ausgangssignals von der Baugruppe 8 zum A/D-Wandler 9, der seinerseits über einen Taktgenerator 18 gesteuert ist, erfolgt in der Schaltstellung I des ausgangsseitigen Umschalters 35.

Die digitale Signalverarbeitung in der letzten Zwischenfrequenz, die z. B. bei 20 MHz liegt, ermöglicht die Realisierung beliebiger Filter, auch solcher, die in der Analogtechnik durch die begrenzte Güte und maximale Anzahl der Resonanzkreise nicht möglich ist. Diese Art der digitalen ZF-Verarbeitung bietet vor allem auch die Möglichkeit, ein Basisbandsignal, das im Frequenzbereich von 0 bis zum halben A/D-Wandler-Takt liegt, mit Hilfe der Fast-Fourier-Transformation zu analysieren. Im Betrieb als Spektrumanalysator wird so durch automatisches Durchfahren des interessierenden Eingangsfrequenzbereiches auf dem Bildschirm 11 die Signalamplitude über der Frequenz angezeigt.

Die Steuerung der einzelnen Baugruppen zur Erzeugung der in der Frequenz durchstimmbaren Oszillatorfrequenz für die erste Frequenzumsetzung und auch für die digitale Signalverarbeitung erfolgt in bekannter Weise über eine zentrale Steuereinheit 19, durch die auch die beiden Umschalter 34 und 35 gesteuert sind.

Bei Betrieb des Meßgeräts zum Messen des Phasenrauschens eines Eingangssignals HF, beispielsweise der Ausgangsfrequenz eines Oszillators, werden gesteuert durch die Steuereinheit 19 die beiden Umschalter 34 und 35 in die Schaltstellung II umgeschaltet. Das Eingangssignal HF wird dadurch nach Durchlaufen des Abschwächers 1 dem Eingang eines zusätzlichen Mischers 30 zugeführt, dem als Überlagerungsfrequenz L0 die Ausgangsfrequenz des in der Frequenz durchstimmbaren ersten Oszillators 12 bis 15 geteilt durch den Teilungsfaktor N eines Frequenzteilers 33 zugeführt wird. Durch die Frequenzteilung im Teiler 33 wird das Phasenrauschen des ersten Überlagerungsoszillators so verbessert, daß er gleich gut wie ein üblicher Signalgenerator ist, wie er bisher bei den eingangs erwähnten Meßplätzen benutzt wird.

Eine andere Möglichkeit besteht darin, das Eingangssignal HF über einen Frequenzmultiplizierer 38 um den Faktor M zu vervielfachen und im Mischer 30 entweder mit der ungeteilten Ausgangsfrequenz des ersten Oszillators 12 oder mit der in der Frequenz um den Faktor N geteilten Ausgangsfrequenz dieses ersten Oszillators zu mischen. Durch einen solchen Frequenzvervielfacher wird in der Praxis eine bessere Meßdynamik in Bezug auf Phasenrauschen in großem Trägerabstand (größer als 1 MHz) erreicht, da ein solcher Frequenzvervielfacher im Vergleich zu einem Frequenzteiler rauscharmer realisiert werden kann. In der Ansteuerung und in der Auswertung ergibt sich kein großer Unterschied zwischen einer Phasenrauschmessung auf der Grundwelle oder auf einer Oberwelle, es muß bei der Auswertung im Prozessor das Meßergebnis nur um den Vervielfachungsfaktor mit 20 x LogM korrigiert werden. Je nach Frequenzbereich wird entweder nur mit einem Frequenzvervielfacher oder nur mit einem Frequenzteiler oder mit beiden Möglichkeiten gleichzeitig das Verfahren angewendet. Sowohl der Frequenzteiler 33 als auch der Frequenzvervielfacher 38 sind vorzugsweise auf ganzzahlige Faktoren einstellbar.

Für eine Phasenrauschmessung muß die Frequenz des zu messenden Hochfrequenzsignals HF entweder bekannt sein, wenn nicht kann sie beispielsweise vor Beginn der Messung mit dem gleichen Meßgerät im Spektrumanalysatorbetrieb (Schalterstellung I) gemessen werden. Zu Beginn der Messung wird je nach Größe des zu messenden Hochfrequenzsignals HF der Vervielfachungsfaktor M des Frequenzvervielfachers 38 und/oder der Teilungsfaktor N des Frequenzteilers 33 so eingestellt, daß mit der am ersten Oszillator einstellbaren Ausgangsfrequenz jeweils Frequenzgleichheit der beiden dem Mischer 30 zugeführten Überlagerungsfrequenzen erreicht wird. Bei Beginn der Phasenrauschmessung reicht eine grobe Übereinstimmung der Frequenzen aus. Wenn beispielsweise sowohl ein Frequenzvervielfacher 38 als auch ein Frequenzteiler 33 vorhanden ist - was nicht zwingend notwendig ist, es ist in manchen Anwendungsfällen durchaus ausreichend, entweder nur einen Frequenzvervielfacher oder nur einen Frequenzteiler vorzusehen - und es soll beispielsweise das Phasenrauschen eines Oszillators mit der Ausgangsfrequenz HF von 100 MHz gemessen werden, so wird beispielsweise der Frequenzvervielfacher auf einen Vervielfachungsfaktor M = 8 und der Frequenzteiler 33 auf einen Teilungsfaktor N = 10 eingestellt, der erste Oszillator 12 kann dann auf 8 GHz eingestellt werden, so daß die dem Mischer 30 zugeführten beiden Frequenzen RF und LO jeweils 800 MHz betragen.

Nach grober Einstellung der Frequenz des ersten Oszillators wird anschließend über einen Regelkreis 37 die Ausgangsfrequenz des ersten Oszillators so geregelt, daß die Ausgangsfrequenz des Mischers 30 0 Hz beträgt. Der Regelkreis 37 steuert über einen A/D-Wandler 36 den Synthesizer 15 so, daß die Ausgangsspannung des Mischers 30 auf einem Ausgangspegel von 0 V gehalten wird. Das auf 0 Hz herabgemischte Ausgangssignal des Mischers 30 durchläuft einen Tiefpaß 31 und wird in einem möglichst rauscharmen Verstärker 32 verstärkt.

Über den steuerbaren Einfluß des A/D-Wandlers 36 auf die Synthesizerfrequenz kann die Regelbandbreite eingestellt werden. Da dieser Regelkreis 37 große Spannungen am Ausgang des Mischers 30 vermeidet, spielt bei ausreichender Verstärkung durch den Verstärker 32 das Eigenrauschen des A/D-Wandlers 9 bei der anschließenden FFT-Auswertung für die erreichbare Meßdynamik keine Rolle.

Das Ausgangssignal des Verstärkers 32 wird über die Schaltstellung II des Ausgangs-Umschalters 35 dem A/D-Wandler 9 zugeführt und wird im Signalprozessor 10 nach dem Prinzip der Fast-Fourier-Transformation bezüglich Phasenrauschen ausgewertet, das Ergebnis wird am Bildschirm 11 angezeigt. Da bei dieser Phasenrauschmessung das Eingangssignal auf 0 Hz herabgemischt wird, wird auch eine eventuelle Amplitudenmodulation unterdrückt, so daß wie bei einem üblichen Meßplatz beispielsweise nur das FM-Rauschen eines Oszillators gemessen werden kann. Die FFT-Auswertung erfolgt in bekannter Weise wie bei einem üblichen Meßplatz.

Die Erfindung ist nicht auf das dargestellte Ausführungsbeispiel beschränkt.

## Patentansprüche

1. Meßgerät, das wahlweise zur Spektrumanalyse oder zum Messen des Phasenrauschens eines Hochfrequenzsignals benutzbar ist, umfassend
mindestens eine Zwischenfrequenz-Überlagerungsstufe (3, 12-15; 5, 16; 7, 17),
einen in der Frequenz durchstimmbaren ersten Oszillator (12-15) für die erste Überlagerungsstufe,
einen Analog/Digital-Wandler (9),
einen Signalprozessor (10) zum Auswerten eines Eingangssignals (HF) nach dem Prinzip der Fourier-Transformation,
einen zusätzlichen Mischer (30), einen Tiefpass (31) und einen rauscharmer Verstärker (32) sowie einen zwischen dem einen Eingang des zusätzlichen Mischers (30) und dem durchstimmbaren ersten Oszillator (12 bis 15) angeordneten Frequenzteiler (33) und einen zwischen dem Eingang des Meßgerätes und dem anderen Eingang des zusätzlichen Mischers (30) angeordneten Frequenzvervielfacher (38), und das Meßgerät derart ausgestaltet ist, dass im Betrieb als Spektrumanalysator das Eingangssignal (HF) mittels des durchstimmbaren ersten Oszillators (12 bis 15) sowie der folgenden mindestens einen Zwischenfrequenz-Überlagerungsstufe in eine Zwischenfrequenz umgesetzt, im Analog/Digital-Wandler (9) digitalisiert und im Signalprozessor (10) nach dem Prinzip der schnellen Fourier-Transformation ausgewertet wird,
und zum Messen des Phasenrauschens das Eingangsignal (HF) entweder direkt oder im Frequenzvervielfacher (38) vervielfacht mit der ungeteilten oder mit der im Frequenzteiler (33) geteilten Ausgangsfrequenz des durchstimmbaren ersten Oszillators (12 bis 15) im zusätzlichen Mischer (30) auf die Frequenz Null herabgemischt wird, indem der durchstimmbare Oszillator (12 bis 15) über einen Regelkreis (37) so geregelt ist, dass die Frequenz der dem zusätzlichen Mischer (30) zugeführten Signale gleich ist, und das Ausgangssignal dieses zusätzlichen Mischers (30) den Tiefpass durchläuft (31) und mittels des rauscharmen Verstärkers (32) verstärkt wird und anschließend, nach Digitalisierung im Analog/DigitalWandler (9), im Signalprozessor (10) nach dem zur Phasenrauschmessung bekannten Prinzip der Fourier-Transformation ausgewertet wird.

2. Meßgerät nach Anspruch 1, **dadurch gekennzeichnet, dass** das Meßgerät derart ausgestaltet ist, dass das Teilungsverhältnis (N) des Frequenzteilers (33) und/oder der Vervielfachungsfaktor (M) des Frequenzvervielfachers (38) einstellbar sind.

3. Meßgerät nach Anspruch 2, **dadurch gekennzeichnet, daß** das Meßgerät derart ausgestaltet ist, dass das Teilungsverhältnis (N)des Frequenzteilers (33) und/oder der Vervielfachungsfaktor (M) des Frequenzvervielfachers (38) auf ganzzahlige Faktoren einstellbar sind.

4. Meßgerät nach einem der vorhergehenden Ansprüche, **dadurch gekennzeichnet, dass** vor der ersten Zwischenfrequenz-Überlagerungsstufe (3, 12-15) und vor dem Analog/Digital-Wandler (9) jeweils ein Umschalter (34, 35) angeordnet ist und das Meßgerät derart ausgestaltet ist, dass zum Betrieb als Spektrumanalysator in der einen Schaltstellung (I) dieser Umschalter (34, 35) das Eingangssignal (HF) der ersten Zwischenfrequenz-Überlagerungsstufe (3) und das Zwischenfrequenzsignal der ersten Zwischenfrequenz-Überlagerungsstufe (3) dem Analog/Digital-Wandler (9) zugeführt wird, während in der anderen Schaltstellung (II) dieser Umschalter (34, 35) das Eingangssignal (HF) dem zusätzlichen Mischer (30) und dessen Ausgangssignal dem Analog/Digital-Wandler (9) zugeführt wird.

5. Meßgerät nach einem der vorhergehenden Ansprüche, **dadurch gekennzeichnet, dass** das Meßgerät zusätzlich einen in der Frequenz durchstimmbaren Synthesizer (15) und einen weiteren Analog/DigitalWandler (36) umfasst und das Meßgerät derart ausgestaltet ist, dass die erste Überlagerungsfrequenz für die erste Zwischenfrequenz-Überlagerungsstufe (3) über den in der Frequenz durchstimmbaren ersten Oszillator (12 bis 14) erzeugt wird, der phasengeregelt ist und seinerseits über den in der Frequenz durchstimmbaren Synthesizer (15) synchronisiert ist, wobei zum Messen des Phasenrauschens das in dem weiteren Analog/DigitalWandler (36) digitalisierte Ausgangssignal des zusätzlichen Mischers (30) den Synthesizer (15) so regelt, dass der in der Frequenz durchstimmbare erste Oszillator (12) eine Frequenz erzeugt, die am Ausgang des Mischers (30) eine Differenzfrequenz von 0 Hz ergibt.

6. Meßgerät nach einem der vorhergehenden Ansprüche, **dadurch gekennzeichnet, dass** das Meßgerät zumindest eine weitere, vorzugsweise zwei weitere, Zwischenfrequenz-Überlagerungsstufen aufweist und das Meßgerät derart ausgestaltet ist, dass für den Betrieb als Spektrumanalysator das mittels des in der Frequenz durchstimmbaren ersten Oszillators in eine erste Zwischenfrequenz (ZF1) umgesetzte Ausgangssignal in mindestens einer weiteren, vorzugsweise in zwei weiteren Zwischenfrequenz-Überlagerungsstufen (5, 16; 7, 17) mit fester Überlagerungsfrequenz auf die letzte Zwischenfrequenz (ZF3) umgesetzt wird, die dann im Analog/Digital-Wandler (9) digitalisiert wird.

## Claims

1. Measuring device, which can be used optionally for spectrum analysis or for measuring the phase jitter of a high-frequency signal, comprising at least one intermediate-frequency superposition stage (3, 12-15; 5, 16; 7, 17),
a variable-frequency first oscillator (12-15) for the first superposition stage,
an analog/digital converter (9),
a signal processor (10) for evaluating an input signal (HF) according to the Fast Fourier Transform principle,
a supplementary mixer (30), a low pass (31) and a low-noise amplifier (32) and also
a frequency divider (33) disposed between the one input of the supplementary mixer (30) and the variable first oscillator (12 to 15) and a frequency multiplier (38) disposed between the input of the measuring device and the other input of the supplementary mixer (30),
and the measuring device is configured such that, in the operating mode as a spectrum analyser, the input signal (HF) is converted by means of the variable first oscillator (12 to 15) and the subsequent at least one intermediate-frequency superposition stage into an intermediate frequency, digitised in the analog/digital converter (9) and evaluated in the signal processor (10) according to the Fast Fourier Transform principle, and for the measurement of the phase jitter, the input signal (HF) is either multiplied directly or in the frequency multiplier (38), mixed down to the frequency zero in the supplementary mixer (30) with the undivided or with the output frequency of the variable first oscillator (12 to 15), divided in the frequency divider (33), in that the variable oscillator (12 to 15) is controlled via a control circuit (37) in such a manner that the frequency of the signals supplied to the supplementary mixer (30) is the same, and the output signal of this supplementary mixer (30) traverses the low pass (31) and is amplified by means of the low-noise amplifier (32) and subsequently, after digitisation in the analog/digital converter (9), is evaluated in the signal processor (10) according to the known Fast Fourier Transform principle for phase-jitter measurement.

2. Measuring device according to claim 1,
**characterised in that**
the measuring device is configured such that the division ratio (N) of the frequency divider (33) and/or the multiplication factor (M) of the frequency multiplier (38) are adjustable.

3. Measuring device according to claim 2,
**characterised in that**
the measuring device is configured such that the division ratio (N) of the frequency divider (33) and/or the multiplication factor (M) of the frequency multiplier (38) are adjustable to integer factors.

4. Measuring device according to any one of the preceding claims,
**characterised in that**
a switching unit (34, 35) is disposed respectively before the first intermediate-frequency superposition stage (3, 12-15) and before the analog/digital converter (9) and the measuring device is configured such that, for operation as a spectrum analyser, in the one switching position (I) of this switching unit (34, 35), the input signal (HF) of the first intermediate-frequency superposition stage (3) and the intermediate frequency signal of the first intermediate-frequency superposition stage (3) are supplied to the analog/digital converter (9); while, in the other switching position (II) of this switching unit (34, 35), the input signal (HF) is supplied to the supplementary mixer (30), and its output signal is supplied to the analog/digital converter (9).

5. Measuring device according to any one of the preceding claims,
**characterised in that**
the measuring device additionally comprises a variable-frequency synthesiser (15) and a further analog/digital converter (36) and the measuring device is configured such that the first superposed frequency for the first intermediate-frequency superposition stage (3) is generated via the variable-frequency first oscillator (12 to 14), which is phase-controlled and, for its part, is synchronised via the variable-frequency synthesiser (15), wherein, for the measurement of phase jitter, the output signal of the supplementary mixer (30), digitised in the further analog/digital converter (36), controls the synthesiser (15) in such a manner that the variable-frequency first oscillator (12) generates a frequency, which gives a differential frequency of 0 Hz at the output of the mixer (30).

6. Measuring device according to any one of the preceding claims,
**characterised in that**
the measuring device has at least one further, preferably two further, intermediate-frequency superposition stages and the measuring device is configured such that, for operation as a spectrum analyser, the output signal, converted by means of the variable-frequency first oscillator into a first intermediate frequency (ZF1), is converted in the at least one further, preferably in the two further intermediate-frequency superposition stages (5, 16; 7, 17), with a fixed superposed frequency to the last intermediate frequency (ZF3), which is then digitised in the analog/digital converter (9).

## Revendications

1. Appareil de mesure, utilisable sélectivement pour l'analyse spectrale ou pour la mesure du bruit de phase d'un signal haute fréquence, comprenant
au moins un étage de superposition de fréquence intermédiaire (3, 12-15 ; 5, 16 ; 7, 17),
un premier oscillateur à fréquence variable (12-15) pour le premier étage de superposition,
un convertisseur analogique-numérique (9),
un processeur de signaux (10) pour l'analyse d'un signal d'entrée (HF) suivant le principe de la transformée de Fourier,
un mélangeur additionnel (30), un filtre passe-bas (31) et un amplificateur à faible bruit (32),
ainsi qu'un diviseur de fréquence (33) disposé entre l'entrée du mélangeur additionnel (30) et le premier oscillateur à fréquence variable (12 à 15), et un multiplicateur de fréquence (38) disposé entre l'entrée de l'appareil de mesure et l'autre entrée du mélangeur additionnel (30),
et appareil de mesure est réalisé de telle manière que, pour le fonctionnement en tant qu'analyseur de spectre, le signal d'entrée (HF) est converti à une fréquence intermédiaire au moyen du premier oscillateur à fréquence variable (12 à 15) ainsi que dudit au moins un étage de superposition de fréquence intermédiaire consécutif, est numérisé dans le convertisseur analogique-numérique (9) et est analysé dans le processeur de signaux (10) suivant le principe de la transformée de Fourier rapide,
et que, pour la mesure du bruit de phase, le signal d'entrée (HF) est multiplié directement ou dans le multiplicateur de fréquence (38) par la fréquence de sortie du premier oscillateur à fréquence variable (12 à 15), non divisée ou divisée dans le diviseur de fréquence (33), est mélangé vers une fréquence zéro dans le mélangeur additionnel (30), l'oscillateur à fréquence variable (12 à 15) étant réglé au moyen d'une boucle d'asservissement (37) pour que la fréquence des signaux acheminés vers le mélangeur additionnel (30) soit identique, et que le signal de sortie dudit mélangeur additionnel (30) traverse le filtre passe-bas (31) et est amplifié au moyen de l'amplificateur à faible bruit (32) puis, après numérisation dans le convertisseur analogique-numérique (9), est analysé dans le processeur de signaux (10) suivant le principe de la transformée de Fourier connu pour la mesure du bruit de phase.

2. Appareil de mesure selon la revendication 1,
**caractérisé**
**en ce que** l'appareil de mesure est réalisé de manière à permettre un réglage du rapport de division (N) du diviseur de fréquences (33) et/ou du facteur de multiplication (M) du multiplicateur de fréquence (38).

3. Appareil de mesure selon la revendication 2,
**caractérisé**
**en ce que** l'appareil de mesure est réalisé de manière à permettre un réglage à des facteurs entiers du rapport de division (N) du diviseur de fréquences (33) et/ou du facteur de multiplication (M) du multiplicateur de fréquence (38).

4. Appareil de mesure selon l'une des revendications précédentes,
**caractérisé**
**en ce qu'**un commutateur (34, 35) respectif est disposé en amont du premier étage de superposition de fréquence intermédiaire (3, 12-15) et en amont du convertisseur analogique-numérique (9), **en ce que** l'appareil de mesure est réalisé de telle manière que, pour le fonctionnement en tant qu'analyseur de spectre, dans la première position de commutation (I) desdits commutateurs (34, 35), le signal d'entrée (HF) du premier étage de superposition de fréquence intermédiaire (3) et le signal de fréquence intermédiaire du premier étage de superposition de fréquence intermédiaire (3) sont acheminés vers le convertisseur analogique-numérique (9) alors que, dans l'autre position de commutation (II) desdits commutateurs (34, 35), le signal d'entrée (HF) est acheminé vers le mélangeur additionnel (30) et le signal de sortie de celui-ci est acheminé vers le convertisseur analogique-numérique (9).

5. Appareil de mesure selon l'une des revendications précédentes,
**caractérisé**
**en ce que** l'appareil de mesure comprend en outre un synthétiseur à fréquence variable (15) et un autre convertisseur analogique-numérique (36), et **en ce que** l'appareil de mesure est réalisé de telle manière que la première fréquence de battement pour le premier étage de superposition de fréquence intermédiaire (3) est générée au moyen du premier oscillateur à fréquence variable (12 à 14), lequel est asservi en phase et est lui-même synchronisé par le synthétiseur à fréquence variable (15), dans lequel le signal de sortie du mélangeur additionnel (30) numérisé dans l'autre convertisseur analogique-numérique (36) asservit le synthétiseur (15) pour la mesure du bruit de phase, de telle manière que le premier oscillateur à fréquence variable (12) génère une fréquence donnant un différentiel de fréquence de 0 Hz à la sortie du mélangeur (30).

6. Appareil de mesure selon l'une des revendications précédentes,
**caractérisé**
**en ce que** l'appareil de mesure présente au moins un, préférentiellement deux autres étages de superposition de fréquence intermédiaire, et **en ce que** l'appareil de mesure est réalisé de telle manière que, pour le fonctionnement en tant qu'analyseur de spectre, le signal de sortie converti à une première fréquence intermédiaire (ZF1) au moyen du premier oscillateur à fréquence variable est converti à la dernière fréquence intermédiaire dans au moins un, préférentiellement deux autres étages de superposition de fréquence intermédiaire (5, 16 ; 7, 17) à fréquence de battement fixe (ZF3), ladite fréquence étant ensuite numérisée dans le convertisseur analogique-numérique (9).
